# EUROPEAN PATENT APPLICATION

(11) **EP 3 561 855 A1**
(43) Date of publication of application: **30.10.2019**
(21) Application number: 17883435.4
(22) Date of filing: 18.12.2017
(51) Int. Cl.: H01L 21/205, C23C 16/34, C23C 16/44, C30B 29/38, H01L 33/32

(54) **GROUP III NITRIDE SEMICONDUCTOR SUBSTRATE AND PRODUCTION METHOD FOR GROUP III NITRIDE SEMICONDUCTOR SUBSTRATE**

(30) Priority: 20.12.2016 JP 2016246908
(71) Applicant: Furukawa Co., Ltd., Chiyoda-ku Tokyo 100-8370 (JP)
(72) Inventor: SUMIDA Yasunobu, Tokyo 100-8370 (JP); FUJIYAMA Yasuharu, Oyama-shi Tochigi 323-8601 (JP); GOTO Hiroki, Oyama-shi Tochigi 323-8601 (JP); NAKAGAWA Takuya, Oyama-shi Tochigi 323-8601 (JP); ISHIHARA Yujiro, Oyama-shi Tochigi 323-8601 (JP)
(74) Representative: Schnappauf, Georg
(86) International application number: PCT/JP2017/045391
(87) International publication number: WO 2018/117050

(57) **Abstract**

Provided is a method for manufacturing a group III nitride semiconductor substrate includes a substrate preparation step S10 of preparing a sapphire substrate, a heat treatment step S20 of performing a heat treatment on the sapphire substrate, a pre-flow step S30 of supplying a metal-containing gas over the sapphire substrate, a buffer layer forming step S40 of forming a buffer layer over the sapphire substrate under growth conditions of a growth temperature of 800°C or higher and 950°C or lower and a pressure of 30 torr or more and 200 torr or less, and a growth step S50 of forming a group III nitride semiconductor layer over the buffer layer under growth conditions of a growth temperature of 800°C or higher and 1025°C or lower, a pressure of 30 torr or more and 200 torr or less, and a growth speed of 10 µm/h or more.

## Description

### TECHNICAL FIELD

The present invention relates to a group III nitride semiconductor substrate and a method for manufacturing a group III nitride semiconductor substrate.

### BACKGROUND ART

Related techniques are disclosed in Patent Document 1 and Patent Document 2. As disclosed in Patent Document 1 and Patent Document 2, in a case where a device (for example, an optical device, an electronic device, or the like) is formed over the c-plane of a group III nitride semiconductor crystal, the internal quantum efficiency is reduced due to a piezoelectric field. Therefore, attempts are being made to form devices over so-called semipolar planes (planes different from polar planes and non-polar planes).

In addition, related techniques are disclosed in Patent Document 3 and Patent Document 4. As disclosed in Patent Document 3 and Patent Document 4, attempts are being made to manufacture group III nitride semiconductor crystals having a semipolar plane as the main surface, which are produced by cutting out crystal pieces having a semipolar plane as a main surface from a bulk group III nitride semiconductor crystal and bonding the crystal pieces.

In addition, related techniques are disclosed in Patent Document 5. As disclosed in Patent Document 5, attempts are being made to manufacture a GaN-based semiconductor optical element having a (20-21) plane and a (20-2-1) plane, which are semipolar planes inclined from the c-plane in the m-axis direction, as the main surfaces.

### RELATED DOCUMENT

### PATENT DOCUMENT

[Patent Document 1] Japanese Patent Application Publication No. 2012-160755
[Patent Document 2] Japanese Patent Application Publication No. 2016-12717
[Patent Document 3] Japanese Patent Application Publication No. 2010-13298
[Patent Document 4] Japanese Patent Application Publication No. 2013-82628
[Patent Document 5] Japanese Patent Application Publication No. 2012-15555

### SUMMARY OF THE INVENTION

### TECHNICAL PROBLEM

An object of the present invention is to provide a technique for improving the internal quantum efficiency of a device formed over a group III nitride semiconductor substrate.

### SOLUTION TO PROBLEM

According to the present invention, there is provided a group III nitride semiconductor substrate including a group III nitride semiconductor crystal, in which the group III nitride semiconductor substrate has a film thickness of 400 µm or more, in which exposed first and second main surfaces of the group III nitride semiconductor substrate, having a front and rear relationship, are both semipolar planes, and in which a difference in half width of an X-ray Rocking Curve (XRC) between the first and second main surfaces, in which X-rays incident to each surface in parallel with a projection axis of a c-axis of the group III nitride semiconductor crystal are measured, is 100 arcsec or less.

In addition, according to the present invention, there is provided a group III nitride semiconductor substrate including a sapphire substrate, and a group III nitride semiconductor layer formed over the sapphire substrate and having an exposed main surface which is semipolar and N-polar.

In addition, according to the present invention, there is provided a method for manufacturing a group III nitride semiconductor substrate, the method including a substrate preparation step of preparing a sapphire substrate, a heat treatment step of performing a heat treatment on the sapphire substrate after the substrate preparation step, a pre-flow step of supplying a metal-containing gas over the sapphire substrate after the heat treatment step, a buffer layer forming step of forming a buffer layer over the sapphire substrate under growth conditions of a growth temperature of 800°C or higher and 950°C or lower and a pressure of 30 torr or more and 200 torr or less after the pre-flow step, and a growth step of forming a group III nitride semiconductor layer over the buffer layer under growth conditions of a growth temperature of 800°C or higher and 1025°C or lower, a pressure of 30 torr or more and 200 torr or less, and a growth speed of 10 µm/h or more, after the buffer layer forming step.

### ADVANTAGEOUS EFFECTS OF INVENTION

According to the present invention, it is possible to improve the internal quantum efficiency of a device formed over a group III nitride semiconductor substrate.

### BRIEF DESCRIPTION OF THE DRAWINGS

The objects described above, other objects, characteristics, and advantages will be made clearer from the preferable embodiments and associated drawings described below.
Fig. 1 is a view showing characteristics of a group III nitride semiconductor substrate of the present embodiment.
Fig. 2 is an Example showing a difference from the group III nitride semiconductor substrate of the present embodiment.
Fig. 3 is a flowchart showing an example of a treatment flow of the method for manufacturing a group III nitride semiconductor substrate of the present embodiment.
Fig. 4 is a schematic side view showing an example of the group III nitride semiconductor substrate of the present embodiment.
Fig. 5 is a schematic side view showing an example of the group III nitride semiconductor substrate of the present embodiment.
Fig. 6 is a view showing characteristics of the group III nitride semiconductor substrate of the present embodiment.
Fig. 7 is a view showing characteristics of the group III nitride semiconductor substrate of the present embodiment.
Fig. 8 is a view showing a difference from the group III nitride semiconductor substrate of the present embodiment.
Fig. 9 is a view showing characteristics of the group III nitride semiconductor substrate of the present embodiment.

### DESCRIPTION OF EMBODIMENTS

A description will be given below of embodiments of a group III nitride semiconductor substrate and a method for manufacturing a group III nitride semiconductor substrate of the present invention using the drawings. The drawings are merely schematic views for illustrating the configuration of the invention, and the size, shape, and number of each member, the ratios of sizes of different members, and the like are not limited to the illustrated examples.

First, a description will be given of a summary of the present embodiment. According to the method for manufacturing a group III nitride semiconductor substrate of the present embodiment, including plural characteristic steps, it is possible to grow a group III nitride semiconductor over a sapphire substrate with a semipolar plane on the N-polarity side as a growth plane. As a result, it is possible to obtain a group III nitride semiconductor substrate (template substrate) in which a group III nitride semiconductor layer, in which an exposed surface is a semipolar plane on the N-polarity side, is positioned over a sapphire substrate. In addition, it is possible to obtain a group III nitride semiconductor substrate (free-standing substrate) including a group III nitride semiconductor layer obtained by growing a group III nitride semiconductor with a semipolar plane on the N-polarity side as a growth plane by peeling the sapphire substrate from the laminate.

Forming devices over such a group III nitride semiconductor substrate (template substrate or free-standing substrate) realizes an improvement in internal quantum efficiency. A detailed description will be given below.

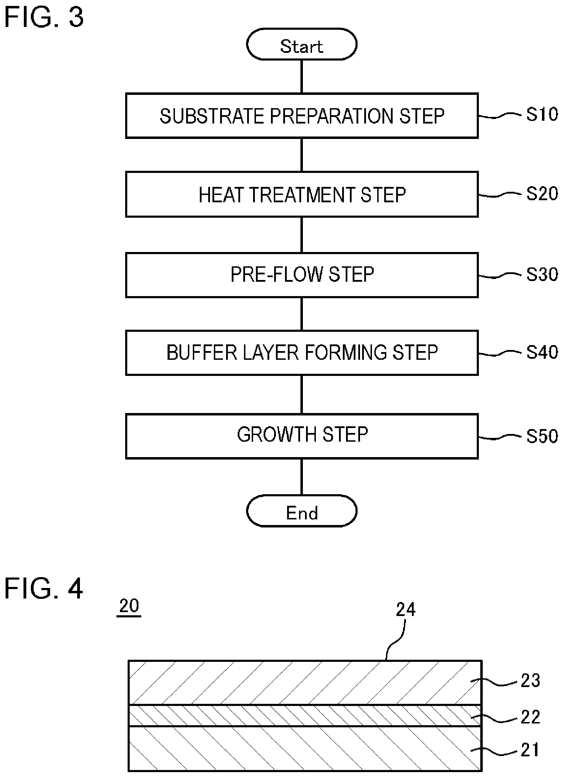

First, a description will be given of a method for manufacturing a group III nitride semiconductor substrate (template substrate). Fig. 3 is a flowchart showing an example of a treatment flow of a method for manufacturing a group III nitride semiconductor substrate (template substrate). As illustrated, the method for manufacturing a group III nitride semiconductor substrate (template substrate) has a substrate preparation step S10, a heat treatment step S20, a pre-flow step S30, a buffer layer forming step S40, and a growth step S50.

In the substrate preparation step S10, a sapphire substrate is prepared. The diameter of the sapphire substrate is, for example, 1 inch or more. In addition, the thickness of the sapphire substrate is, for example, 250 µm or more.

The plane orientation of the main surface of the sapphire substrate is one of plural factors controlling the plane orientation of the growth plane of the group III nitride semiconductor layer epitaxially grown thereover. The relationship between this factor and the plane orientation of the growth plane of the group III nitride semiconductor layer is shown in the following Examples. In the substrate preparation step S10, a sapphire substrate in which the main surface has a desired plane orientation is prepared.

The main surface of the sapphire substrate is, for example, a {10-10} plane or a plane obtained by inclining the {10-10} plane at a predetermined angle in a predetermined direction.

The plane obtained by inclining the {10-10} plane at a predetermined angle in a predetermined direction may be, for example, a plane obtained by inclining the {10-10} plane at any angle greater than 0° and 0.5° or less in an arbitrary direction.

In addition, the plane obtained by inclining the {10-10} plane at a predetermined angle in a predetermined direction may be a plane obtained by inclining the {10-10} plane at any angle greater than 0° and less than 10.5° in a direction in which the {10-10} plan is parallel to the a-plane. Alternatively, the plane obtained by inclining the {10-10} plane at a predetermined angle in a predetermined direction may be a plane obtained by inclining the {10-10} plane at any angle greater than 0° and 10.5° or less in a direction in which the {10-10} plan is parallel to the a-plane. For example, a plane obtained by inclining the {10-10} plane at a predetermined angle in a predetermined direction may be a plane obtained by inclining the {10-10} plane at any angle of 0.5° or more and 1.5° or less, 1.5° or more and 2.5° or less, 4.5° or more and 5.5° or less, 6.5° or more and 7.5° or less, and 9.5° or more and 10.5° or less in a direction in which the {10-10} plan is parallel to the a-plane.

The heat treatment step S20 is performed after the substrate preparation step S10. In the heat treatment step S10, the heat treatment is performed on the sapphire substrate under the following conditions.
Temperature: 800°C or higher and 1200°C or lower
Pressure: 30 torr or more to 760 torr or less
Heat treatment time: 5 minutes or more and 20 minutes or less
Carrier gas: H₂, or H₂ and N₂ (H₂ ratio 0 to 100%)
Carrier gas supply rate: 3 slm or more and 50 slm or less (however, since the supply rate changes according to the size of the growth apparatus, the supply rate is not limited thereto.)

Here, the heat treatment on the sapphire substrate may be performed while performing a nitriding treatment, or may be performed without performing a nitriding treatment. In a case where the heat treatment is performed while performing the nitriding treatment, NH₃ is supplied at 0.5 slm or more and 20 slm or less over the sapphire substrate during the heat treatment (however, since the supply rate changes depending on the size of the growth apparatus, the supply rate is not limited thereto) . In addition, in a case where the heat treatment is performed without performing the nitriding treatment, NH₃ is not supplied during the heat treatment.

The presence or absence of the nitriding treatment during the heat treatment may be one of plural factors controlling the plane orientation of the growth plane of the group III nitride semiconductor layer epitaxially grown over the main surface of the sapphire substrate. The relationship between this factor and the plane orientation of the growth plane of the group III nitride semiconductor layer is shown in the following Examples.

The pre-flow step S30 is performed after the heat treatment step S20. In the pre-flow step S30, a metal-containing gas is supplied over the main surface of the sapphire substrate under the following conditions. The pre-flow step S30 may be performed, for example, in a Metal Organic Chemical Vapor Deposition (MOCVD) apparatus.
Temperature: 500°C or higher and 1000°C or lower
Pressure: 30 torr or more and 200 torr or less
Trimethylaluminum supply rate, supply time: 20 ccm or more and 500 ccm or less, 1 second or more and 60 seconds or less
Carrier gas: H2, or H2 and N2 (H2 ratio 0 to 100%)
Carrier gas supply rate: 3 slm or more and 50 slm or less (However, since the gas supply rate changes depending on the size and configuration of the growth apparatus, the gas supply rate is not limited thereto.)

The conditions described above are in a case of supplying trimethylaluminum and triethylaluminum, which are organic metal materials, as the metal-containing gas. In this step, a metal-containing gas containing another metal may be supplied instead of trimethylaluminum triethylaluminum, and another metal film such as a titanium film, a vanadium film, or a copper film may be formed over the main surface of the sapphire substrate instead of the aluminum film. In addition, other metal carbide films such as aluminum carbide, titanium carbide, vanadium carbide, and copper carbide, which are reaction films with hydrocarbon compounds such as methane, ethylene, or ethane generated from organic metal raw materials, may be formed over the main surface of the sapphire substrate.

In the pre-flow step S30, a metal film and a metal carbide film are formed over the main surface of the sapphire substrate. The presence of the metal film is a condition for reversing the polarity of the crystal grown thereover. That is, the implementation of the pre-flow step S30 is one of plural factors for setting the plane orientation of the growth plane of the group III nitride semiconductor layer epitaxially grown over the main surface of the sapphire substrate to the plane on the N-polarity side.

The buffer layer forming step S40 is performed after the pre-flow step S30. In the buffer layer forming step S40, a buffer layer is formed over the main surface of the sapphire substrate. The thickness of the buffer layer is, for example, 20 nm or more and 300 nm or less.

The buffer layer is, for example, an AlN layer. For example, an AlN crystal may be epitaxially grown under the following conditions to form a buffer layer.
Growth method: MOCVD method
Growth temperature: 800°C or higher and 950°C or lower
Pressure: 30 torr or more and 200 torr or less
Trimethylaluminum supply rate: 20 ccm or more and 500 ccm or less
NH₃ supply rate: 0.5 slm or more and 10 slm or less
Carrier gas: H₂, or H₂ and N₂ (H₂ ratio 0 to 100%)
Carrier gas supply rate: 3 slm or more and 50 slm or less (however, since the gas supply rate changes depending on the size and configuration of the growth apparatus, the gas supply rate is not limited thereto.)

The growth conditions for the buffer layer forming step S40 may be one of plural factors controlling the plane orientation of the growth plane of the group III nitride semiconductor layer epitaxially grown over the main surface of the sapphire substrate. The relationship between this factor and the plane orientation of the growth plane of the group III nitride semiconductor layer is shown in the following Examples.

In addition, the growth conditions (relatively low predetermined growth temperature, specifically, 800 to 950°C, and relatively low pressure) in the buffer layer forming step S40 are conditions for growing AlN while maintaining N-polarity. That is, the growth conditions in the buffer layer forming step S40 are one of plural factors for setting the plane orientation of the growth plane of the group III nitride semiconductor layer epitaxially grown over the main surface of the sapphire substrate to the plane on the N-polarity side.

The growth step S50 is performed after the buffer layer forming step S40. In the growth step S50, a group III nitride semiconductor crystal (for example: GaN crystal) is epitaxially grown over the buffer layer under the following growth conditions, and a group III nitride semiconductor layer is formed in which the growth plane has a predetermined plane orientation (semipolar plane on the N-polarity side) . The thickness of a group III nitride semiconductor layer 30 is, for example, 1 µm or more and 20 µm or less.
Growth method: MOCVD method
Growth temperature: 800°C or higher to 1025°C or lower
Pressure: 30 torr or more and 200 torr or less
TMGa supply rate: 25 sccm or more and 1000 sccm or less
NH₃ supply rate: 1 slm or more and 20 slm or less
Carrier gas: H₂, or H₂ and N₂ (H₂ ratio 0 to 100%)
Carrier gas supply rate: 3 slm or more and 50 slm or less (however, since the gas supply rate changes depending on the size and configuration of the growth apparatus, the gas supply rate is not limited thereto.)
Growth speed: 10 µm/h or more

The growth conditions (relatively low growth temperature, relatively low pressure, and relatively fast growth rate) in the growth step S50 are conditions for growing GaN while maintaining the N-polarity. That is, the growth conditions in the growth step S50 are one of plural factors for setting the plane orientation of the growth plane of the group III nitride semiconductor layer epitaxially grown over the main surface of the sapphire substrate to the plane on the N-polarity side.

By manufacturing under the above conditions, as shown in Fig. 4, it is possible to manufacture a group III nitride semiconductor substrate 20 in which the sapphire substrate 21, the buffer layer 22, and the group III nitride semiconductor layer 23 are laminated in this order, and the plane orientation of the growth plane 24 of the group III nitride semiconductor layer 23 is a semipolar plane on the N-polarity side. In addition, adjusting the manufacturing conditions in the range of the above conditions makes it possible to set the plane orientation of the growth plane 24 to a desired semipolar plane.

Next, a description will be given of a method for manufacturing a group III nitride semiconductor substrate (free-standing substrate).

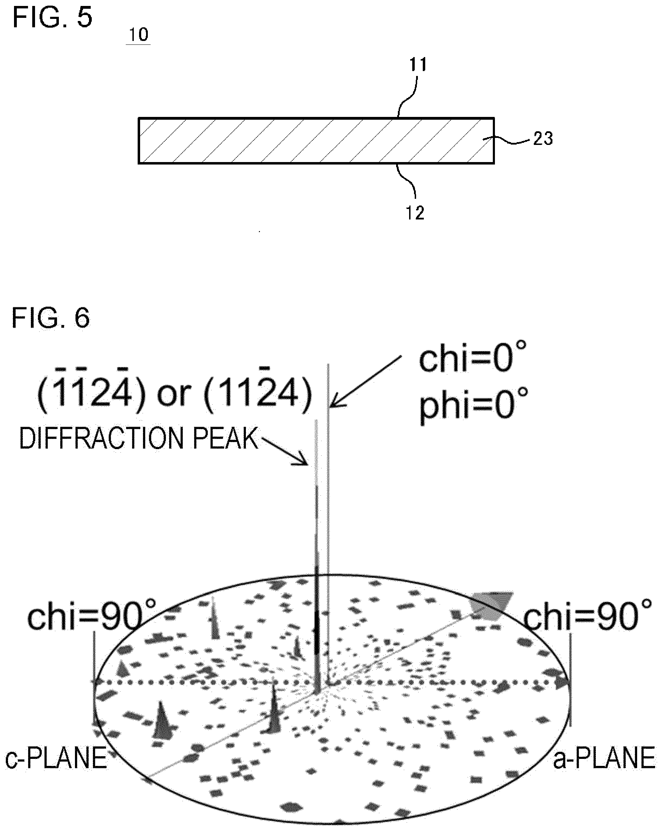

For example, it is possible to manufacture the group III nitride semiconductor substrate 10 (free-standing substrate) including the group III nitride semiconductor layer 23 as shown in Fig. 5 by manufacturing the laminate (template substrate) as shown in Fig. 4 with the flow shown in Fig. 3, and then removing the sapphire substrate 21 and the buffer layer 22 from the laminate (peeling step). The means for removing the sapphire substrate 21 and the buffer layer 22 is not particularly limited. For example, stress caused by the difference in linear expansion coefficient between the sapphire substrate 21 and the group III nitride semiconductor layer 23 may be used for the separation. Then, the buffer layer 22 may be removed by polishing, etching, or the like.

As another example of removal, a peeling layer may be formed between the sapphire substrate 21 and the buffer layer 22. For example, after forming a carbon layer in which carbide (aluminum carbide, titanium carbide, zirconium carbide, hafnium carbide, vanadium carbide, or tantalum carbide) is dispersed, and a laminate of layers of carbide (aluminum carbide, titanium carbide, zirconium carbide, hafnium carbide, vanadium carbide, or tantalum carbide) over the sapphire substrate 21, a layer subjected to a nitriding treatment may be formed as a peeling layer.

When the buffer layer 22 and the group III nitride semiconductor layer 23 are formed over such a peeling layer and then the laminate is heated at a temperature higher than the heating temperature when forming the group III nitride semiconductor layer 23, it is possible to separate the portion on the sapphire substrate 21 side and the portion on the group III nitride semiconductor layer 23 side with a portion of the peeling layer as a boundary. Removing the buffer layer 22 and the like from the portion on the group III nitride semiconductor layer 23 side by polishing, etching, or the like makes it possible to obtain the group III nitride semiconductor substrate 10 (free-standing substrate) including the group III nitride semiconductor layer 23 shown in Fig. 5.

Next, a description will be given of configurations and characteristics of the group III nitride semiconductor substrate 20 (template substrate) and the group III nitride semiconductor substrate 10 (free-standing substrate) obtained by the manufacturing method described above.

As shown in Fig. 4, the group III nitride semiconductor substrate 20 (template substrate) has a sapphire substrate 21, a buffer layer 22 formed over the sapphire substrate 21, and the group III nitride semiconductor layer 23 formed over the buffer layer 22. The plane orientation of the main surface (the growth plane 24) of the group III nitride semiconductor layer 23 is semipolar and N-polar.

The film thickness of the group III nitride semiconductor layer 23 is 1 µm or more. The half width of the X-ray Rocking Curve (XRC) of the main surface (the growth plane 24) of the group III nitride semiconductor layer 23 is 500 arcsec or less in the c-axis projection axis direction.

As described in the following Examples, in a case where a group III nitride semiconductor is epitaxially grown over a semipolar and Ga-polar growth plane, the crystallinity thereof deteriorates as the thickness of the group III nitride semiconductor layer increases. As a result, as the thickness of the group III nitride semiconductor layer increases, the half width of XRC increases. For this reason, in a case where the growth plane is semipolar and Ga-polar, it is difficult to manufacture a group III nitride semiconductor layer having good crystallinity and a thick film.

On the other hand, as shown in Examples below, in a case where a group III nitride semiconductor is epitaxially grown over a semipolar and N-polar growth plane, the crystallinity hardly changes even when the thickness of the group III nitride semiconductor layer increases. In the case of the present embodiment in which the group III nitride semiconductor is epitaxially grown over a semipolar and N-polar growth plane, it is possible to manufacture a thick-film (1 µm or more) group III nitride semiconductor layer 23 as described above in which the crystallinity is good, as described above (the X-ray Rocking Curve (XRC) half width obtained by measuring X-rays incident in parallel with the projection axis of the c axis of the group III nitride semiconductor crystal is 500 arcsec or less).

As shown in Fig. 5, the group III nitride semiconductor substrate 10 (free-standing substrate) includes a group III nitride semiconductor layer 23 formed of a group III nitride semiconductor crystal. The film thickness of the group III nitride semiconductor substrate 10 (free-standing substrate) is 100 µm or more. The first main surface 11 and the second main surface 12, which are exposed and have the front and rear relationship, are both semipolar planes, and a difference in half width of an X-ray Rocking Curve (XRC) between the first main surface 11 and the second main surface 12, obtained by measuring X-rays incident in parallel with a projection axis of a c-axis of the group III nitride semiconductor crystal with respect to each surface, is 100 arcsec or less. The XRC half widths of the first main surface 11 and the second main surface 12 are each 500 arcsec or less in the c-axis projection axis direction.

For example, after epitaxially growing a group III nitride semiconductor, in which the plane orientation of the growth plane is semipolar and Ga-polar, over a sapphire substrate, when the sapphire substrate is removed from the group III nitride semiconductor layer, the external appearance is the same as the group III nitride semiconductor substrate 10 (free-standing substrate) of the present embodiment shown in Fig. 5. However, this substrate and the group III nitride semiconductor substrate 10 (free-standing substrate) of the present embodiment are different in that the growth plane when epitaxially growing the group III nitride semiconductor is "semipolar and Ga-polar" or "semipolar and N-polar".

It is possible to ascertain this difference by looking at the relationship between the film thickness and the difference in XRC half width between the main surfaces which have a front and rear relationship.

As described above, in a case where a group III nitride semiconductor is epitaxially grown over a semipolar and Ga-polar growth plane, the greater the thickness of the group III nitride semiconductor layer, the more the crystallinity deteriorates, and the greater the XRC half width is. That is, the greater the film thickness, the greater the difference in the XRC half width between the main surfaces which have the front and rear relationship.

On the other hand, in a case where the group III nitride semiconductor is epitaxially grown over a semipolar and N-polar growth plane, the crystallinity hardly changes even when the thickness of the group III nitride semiconductor layer increases. That is, even when the film thickness is increased, the difference in the XRC half width between the main surfaces having the front and rear relationship is a predetermined level or less.

As described above, by determining the difference in the half width of XRC between the main surfaces having a front and rear relationship when the film thickness is within a predetermined range, it is possible to ascertain whether the group III nitride semiconductor substrate was epitaxially grown over a "semipolar and Ga-polar" growth plane, or the group III nitride semiconductor substrate was epitaxially grown over a "semipolar and N-polar " growth plane.

Specifically, in a case where it is satisfied that "the difference in the half width of XRC between the main surfaces having the front and rear relationship is 100 arcsec or less in a case where the film thickness is 300 µm or more", it is possible to describe this as a group III nitride semiconductor substrate epitaxially grown over a "semipolar and N-polar" growth plane. Then, in a case where it is satisfied that "the difference in the half width of XRC between the main surfaces having the front and rear relationship is greater than 100 arcsec in a case where the film thickness is 300 µm or more", it is possible to describe this as a group III nitride semiconductor substrate epitaxially grown over a "semipolar and Ga-polar" growth plane.

Next, a description will be given of the operation and effects of the present embodiment.

According to the method for manufacturing a group III nitride semiconductor substrate of the present embodiment, it is possible to grow a group III nitride semiconductor over a sapphire substrate using a semipolar plane on the N-polarity side as a growth plane. As a result, as shown in Fig. 4, the group III nitride semiconductor substrate 20 (template substrate) is obtained in which the group III nitride semiconductor layer 23, in which an exposed surface (growth plane 24) is a semipolar plane on the N-polarity side, is positioned over the sapphire substrate 21. In addition, as shown in Fig. 5, a group III nitride semiconductor substrate 10 (free-standing substrate) including a group III nitride semiconductor layer 23 obtained by growing a group III nitride semiconductor using the semipolar plane on the N-polarity side as a growth plane is obtained.

Forming devices over such a group III nitride semiconductor substrate (template substrate, free-standing substrate) realizes an improvement in internal quantum efficiency.

In addition, using the group III nitride semiconductor substrate (template substrate, free-standing substrate) of the present embodiment makes it possible to form a device over the main surface for which the plane orientation is a semipolar plane on the N-polarity side. In such a case, not only is a reduction in piezo polarization due to the effect of the semipolar plane realized, but a reduction in spontaneous polarization is also realized. Therefore, it is possible to suppress the Stark effect caused by the internal electric field.

In addition, the present inventors ascertained that in a case where the group III nitride semiconductor is grown with the semipolar plane on the N-polarity side as a growth plane, it is easy for the surface state to become flat in comparison with a case where the group III nitride semiconductor was grown with a semipolar plane on the Ga-polarity side as a growth plane . In a case where a group III nitride semiconductor is grown with the semipolar plane on the Ga-polarity side as a growth plane, pits and facets derived from m-plane components tend to occur. The group III nitride semiconductor substrate (template substrate, free-standing substrate) of the present embodiment is also excellent regarding this point.

In addition, the present inventors ascertained that in a case where the group III nitride semiconductor is grown with the semipolar plane on the N-polarity side as a growth plane, the incorporation of impurities is smaller in comparison with a case where the group III nitride semiconductor was grown with a semipolar plane on the Ga-polarity side as a growth plane. Specifically, when HaLL measurement of two types of polar planes (a semipolar plane on the N-polarity side and a semipolar plane on the Ga-polarity side) grown in the same device and under the same growth conditions was performed, it was ascertained that, in a case where a group III nitride semiconductor is grown with a semipolar plane on the N-polarity side as a growth plane, the carrier concentration was one digit smaller in comparison with a case where the group III nitride semiconductor is grown with the semipolar plane on the Ga-polarity side as a growth plane. It is presumed that this is because it was possible to reduce the incorporation of O. The group III nitride semiconductor substrate (template substrate, free-standing substrate) of the present embodiment is also excellent regarding this point.

In addition, according to the present embodiment, there is provided a group III nitride semiconductor substrate having a group III nitride semiconductor layer formed over a sapphire substrate and having exposed main surfaces which are semipolar and N-polar, and having the sapphire substrate as a base substrate. In addition, growing the crystal over the group III nitride semiconductor substrate described above provides a group III nitride semiconductor free-standing substrate in which the exposed first and second main surfaces having a front and rear relationship are both semipolar planes.

For example, one of the exposed first and second main surfaces having a front and rear relationship in the group III-nitride semiconductor free-standing substrate provided by the present embodiment is a semipolar plane inclined from the c-plane at 38.0° or more and 53.0° or less to the a-plane direction and -16.0° or more and 16.0° or less to the m-plane direction, while the other main surface is a semipolar plane inclined from the -c-plane at 38.0° or more and 53.0° or less to the -a-plane direction and -16.0° or more and 16.0° or less to the m-plane direction. In addition, the main surface of the group III nitride semiconductor substrate having a sapphire substrate as the base substrate is, for example, a semipolar plane inclined from the -c-plane at 38.0° or more and 53.0° or less to the a-plane direction and -16.0° or more and 16.0° or less to the m-plane direction.

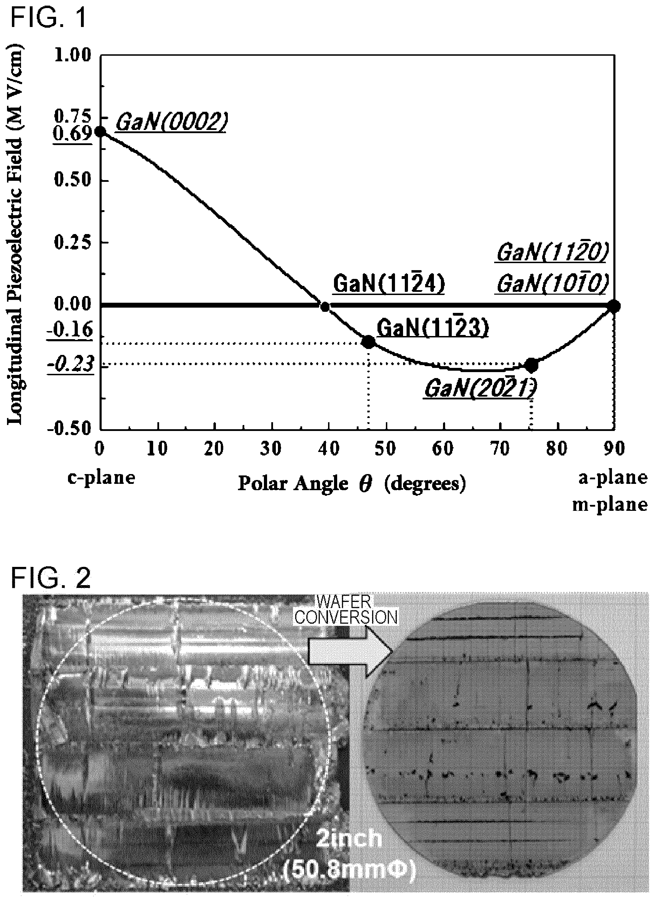

In particular, in a case where a light emitting device (LED, LD) is formed over the main surface, for the plane ((11-24) plane) inclined from the c-plane at 39.1° to the a-plane direction, since the piezoelectric field is zero as shown in Fig. 1 reported in Jpn. J. Appl. Phys. Vol. 39 (2000) pp. 413-416, it is possible to obtain a reduction in power consumption and an improvement in the light emitting efficiency due to the effect of suppressing a decrease in the internal quantum efficiency due to the Stark effect equal to that in the m-plane and the a-plane, which are non-polar planes. In addition, the semipolar and N-polar main surface ((-1-12-4) plane) inclined from the -c-plane at 39.1° to the -a-plane direction not only realizes a reduction in piezo polarization due to the effect of the semipolar plane, but also realizes a reduction in the spontaneous polarization generated from the nitrogen atoms toward the gallium atoms. Therefore, it is possible to further suppress the Stark effect caused by the internal electric field generated in the active layer of the light emitting device (LED or LD), thus, it is possible to obtain a further improvement in the performance of the light emitting device (LED or LD).

The group III nitride semiconductor layers provided in Patent Document 1 and Patent Document 2 both have a semipolar and Ga-polar main surface, and the internal quantum efficiency of the device is low in comparison with the group III nitride semiconductor substrate having a group III nitride semiconductor layer having a semipolar and N-polar main surface and the sapphire substrate provided according to the present embodiment.

If the group III nitride semiconductor substrate having a sapphire substrate as a base substrate provided by the present embodiment is used, when the sapphire substrate is removed by any method including known techniques or commonly used techniques, it is possible to manufacture a group III nitride semiconductor free-standing substrate which has a large diameter equivalent to the size of the sapphire substrate used, which is uniform in in-plane crystallinity of the substrate, surface flatness, impurity concentration, and axial deviation of plane orientation, and which does not need a precise manufacturing technique. The known techniques and commonly used techniques referred to here are, for example, chemical etching, mechanical polishing, crystal peeling using thermal stress, and the like.

The group III nitride semiconductor free-standing substrates provided by the methods of Patent Document 3 and Patent Document 4 are group III nitride semiconductor free-standing substrates in which a semipolar plane is the main surface, produced by bonding crystal pieces cut out in any plane orientation from the group III nitride semiconductor free-standing substrate in which the c-plane is the main surface. In order to realize the above, a step of cutting out a large amount of crystal pieces from a bulk crystal and a step of bonding the crystal pieces in alignment at the same height in the crystal axis direction with high precision are necessary, thus, accurate techniques are necessary in order to realize a high yield. In addition, since the crystal pieces are bonded to increase the diameter of the substrate, shifting in the atomic positions occurs at the bonded portions, and high-density dislocations are generated in these portions. As a result, decreases in the crystallinity of the substrate and unevenness in the in-plane distribution of dislocation density are generated. In addition, in a case where the bonding plane is a c-plane, m-plane, or a plane inclined from the m-plane in the c-plane direction, facet planes such as an {11-22} plane or a {10-11} plane appear, large depressions and crystal growth abnormalities as shown in Fig. 2 occur, thus, the surface flatness deteriorates remarkably, the bonding strength is insufficient, and there are difficulties when handling the substrate.

In addition, in order to solve the difficulty in handling of the substrate due to the remarkable deterioration of the surface flatness caused by the large depressions and the crystal growth abnormalities as shown in Fig. 2 and the insufficient bonding strength, setting the bonding planes to only the a-plane and a plane inclined from the a-plane using the methods of Patent Document 3 and Patent Document 4 may be considered; however, even in this case, it is not possible to solve the generation of dislocations due to shifting in the atomic positions at the bonding plane and the accompanying unevenness in the in-plane distribution of the dislocation density. In addition, since the crystal bonding is performed on the a-plane or the plane inclined from the a-plane, it is not possible to manufacture the group III nitride semiconductor free-standing substrate provided according to the present embodiment with the plane inclined from the a-plane as the main surface.

Since the first and second main surfaces of the group III nitride semiconductor free-standing substrate provided by the present embodiment are both, for example, inclined planes of the a-plane, the first and second main surfaces have cleavage planes (m-planes) on the side planes. Providing a substrate having a cleavage plane makes it possible to easily obtain a reflective mirror plane excellent in flatness, in which atoms are regularly arranged, which is essential for optical resonance in a semiconductor laser (LD).

In the GaN-based semiconductor laser element provided in Patent Document 5 with the (20-21) plane and the (20-2-1) plane as the main surfaces, since the main surface is an inclined plane of the m-plane, there is no cleavage plane on the side plane. Accordingly, it is not possible to obtain a reflective mirror plane with a high level of flatness which is able to obtain optical resonance. Therefore, when manufacturing a product, a high-level and precise technique for flattening the side plane is necessary, and the manufacturing steps are complicated. In addition, since a reflective mirror plane having inferior flatness is used, the performance is deteriorated in comparison with a GaN-based semiconductor optical laser element in which a mirror structure is produced using a cleavage plane.

### [Examples]

### <First Evaluation>

The first evaluation shows that all of the "plural factors for setting the plane orientation of the growth plane of the group III nitride semiconductor layer to the plane on the N-polarity side" described above being satisfied makes it possible to set the plane orientation of the growth plane of the group III nitride semiconductor layer to the plane on the N-polarity side. In addition, the first evaluation shows that, in a case where at least one among the "plural factors for setting the plane orientation of the growth plane of the group III nitride semiconductor layer to the plane on the N-polarity side" was not satisfied, the plane orientation of the growth plane of the group III nitride semiconductor layer is the plane on the Ga-polarity side.

First, a sapphire substrate was prepared in which the plane orientation of the main surface was a plane inclined from the m-plane ((10-10) plane) at 2°C in a direction in which the m-plane is parallel with the a-plane. The thickness of the sapphire substrate was 430 µm and the diameter was 2 inches.

With respect to the prepared sapphire substrate, the heat treatment step S20 was implemented under the following conditions.
Temperature: 1000 to 1050°C
Pressure: 100 torr
Carrier gas: H₂, N₂
Heat treatment time: 10 minutes or 15 minutes
Carrier gas supply rate: 15 slm

In the heat treatment step S20, NH₃ was supplied at 20 slm to perform a nitriding treatment.

Thereafter, a pre-flow step S30 was performed under the following conditions.
Temperature: 800 to 930°C
Pressure: 100 torr
Trimethylaluminum supply rate, supply time: 90 sccm, 10 seconds
Carrier gas: H₂, N₂
Carrier gas supply rate: 15 slm

Then, the buffer layer forming step S40 was performed under the following conditions, and an AlN layer was formed.
Growth method: MOCVD method
Growth temperature: 800 to 930°C
Pressure: 100 torr
Trimethylaluminum supply rate: 90 sccm
NH₃ supply rate: 5 slm
Carrier gas: H₂, N₂
Carrier gas supply rate: 15 slm

Thereafter, the growth step S50 was performed under the following conditions and a group III nitride semiconductor layer was formed.
Growth method: MOCVD method
Pressure: 100 torr
TMGa supply rate: 50 to 500 sccm (continuous change)
NH₃ supply rate: 5 to 10 slm (continuous change)
Carrier gas: H₂, N₂
Carrier gas supply rate: 15 slm
Growth rate: 10 µm/h or more

The growth temperature of a first sample was controlled to be 900°C ±25°C, and the growth temperature of the second sample was controlled to be 1050°C ±25°C. That is, the first sample is a sample which satisfied all of the "plural factors for setting the plane orientation of the growth plane of the group III nitride semiconductor layer to the plane on the N-polarity side" described above. The second sample is a sample which did not satisfy one (the growth temperature in the growth step S50) of the "plural factors for setting the plane orientation of the growth plane of the group III nitride semiconductor layer to the plane on the N-polarity side" described above.

The plane orientation of the growth plane of the group III nitride semiconductor layer of the first sample forms a plane inclined from the (-1-12-4) plane at 5.0° to the -a-plane direction and inclined at 8.5° or more in a direction in which the (-1-12-4) plane is parallel to the m-plane. On the other hand, the plane orientation of the growth plane of the group III nitride semiconductor layer of the second sample was a plane inclined from the (11-24) plane at 5.0° to the a-plane direction and inclined at 8.5° or less in the direction in which the (11-24) plane is parallel with the m-plane. That is, it is understood that it is possible to adjust whether the plane orientation of the growth plane is Ga-polarity or N-polarity, depending on whether or not the "plural factors for setting the plane orientation of the growth plane of the group III nitride semiconductor layer to the plane on the N-polarity side" described above are satisfied.

Fig. 6 shows XRD pole point measurement results of the (-1-12-4) plane or the (11-24) plane in the first sample. It is shown that the diffraction peak is a position shifted several degrees from the center point of the pole point. It is shown that, when the shift in the angle is measured in detail, the peak is a position at 5.0° in the -a-plane direction and 8.5° in a direction in which the plane is parallel to the m-plane or at 5.0° in the a-plane direction and 8.5° in a direction in which the plane is parallel to the m-plane.

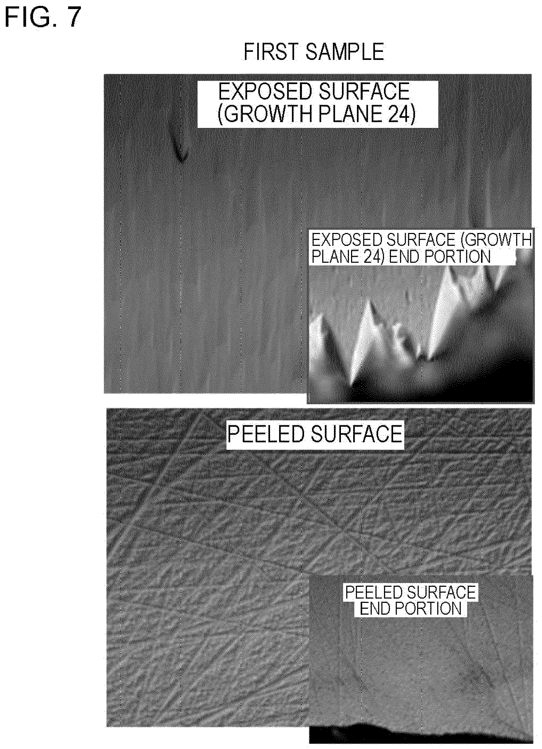

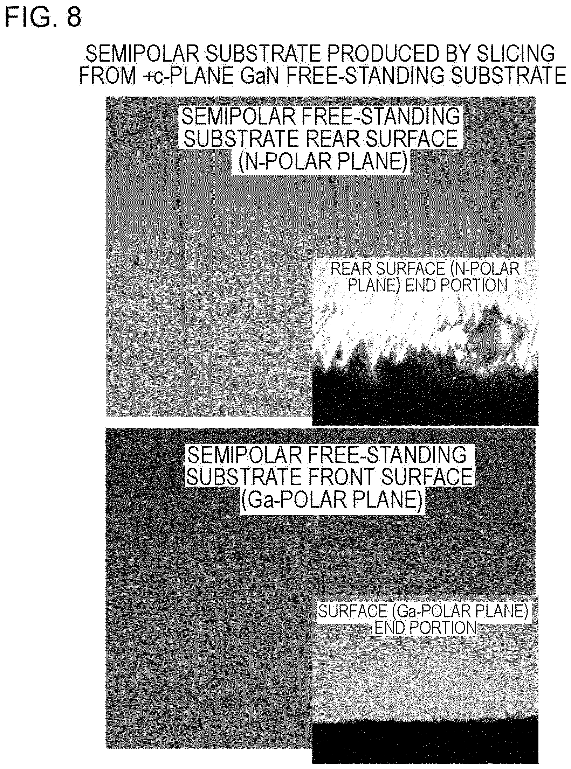

Fig. 7 shows results ascertaining that the exposed surface (growth plane 24) shown in Fig. 4 is N-polar in the first sample. In addition, as a comparison, Fig. 8 shows the result of a group III nitride semiconductor free-standing substrate produced by slicing from a +c plane thick-film-grown GaN free-standing substrate so as to have the same plane orientation as the first sample. The first sample and the semipolar free-standing substrate produced by slicing from the +c plane GaN free-standing substrate were both diamond-polished for 1.5 µm on both sides (front and rear of the substrate), and etching was performed for 30 minutes while maintaining a mixed solution of phosphoric acid and sulfuric acid at 150°C.

Fig. 7 and Fig. 8 show that the etched surface states of the exposed surface (growth plane 24) of the first sample and of the rear surface (N-polar plane) of the semipolar free-standing substrate produced by slicing from a +c-plane GaN free-standing substrate are equal to each other. In addition, since it is shown that the etched surface states of the peeled surface of the first sample and of the surface (Ga-polar plane) of the semipolar free-standing substrate produced by slicing from the +c-plane GaN free-standing substrate are equal to each other, it is possible to confirm that the exposed surface (growth plane 24) shown in Fig. 4 is N-polar.

The present inventors ascertained that, in a case where another factor among the "plural factors for setting the plane orientation of the growth plane of the group III nitride semiconductor layer to the plane on the N-polarity side" described above is not satisfied, or in a case where no factors are satisfied, the plane orientation of the growth plane is Ga-polarity.

### <Second Evaluation>

The second evaluation shows that adjusting the "plural factors for adjusting the plane orientation of the growth plane of the group III nitride semiconductor layer" described above makes it possible to adjust the plane orientation of the growth plane of the group III nitride semiconductor layer.

First, plural sapphire substrates having various main surface orientations were prepared. The sapphire substrates had a thickness of 430 µm and a diameter of 2 inches.

With respect to each prepared sapphire substrate, the heat treatment step S20 was performed under the following conditions.
Temperature: 1000 to 1050°C
Pressure: 200 torr
Heat treatment time: 10 minutes
Carrier gas: H₂, N₂
Carrier gas supply rate: 15 slm

In addition, samples in which the presence or absence of the nitriding treatment was varied at the time of the heat treatment were prepared. Specifically, a sample to which 20 slm of NH₃ was supplied at the time of the heat treatment and which was subjected to a nitride treatment and a sample to which NH₃ was not supplied and which was not subjected to a nitride treatment were prepared.

Thereafter, the pre-flow step S30 was performed under the following conditions.
Temperature: 880 to 930°C
Pressure: 100 torr
Trimethylaluminum supply rate, supply time: 90 sccm, 10 seconds
Carrier gas: H2, N2
Carrier gas supply rate: 15 slm

In addition, both a sample for which the pre-flow step S30 was performed and a sample for which the pre-flow step S30 was not performed were prepared.

Thereafter, a buffer layer (AlN buffer layer) having a thickness of approximately 150 nm was formed over the main surface (exposed surface) of the sapphire substrate under the following conditions.
Growth method: MOCVD method
Pressure: 100 torr
V/III ratio: 5184
TMAl supply rate: 90 ccm
NH₃ supply rate: 5 slm
Carrier gas: H₂, N₂
Carrier gas supply rate: 15 slm

The growth temperature was varied in the range of 700°C or higher and 1110°C or lower for each sample.

Thereafter, a group III nitride semiconductor layer (GaN layer) having a thickness of approximately 15 µm was formed over the buffer layer under the following conditions.
Growth method: MOCVD method
Growth temperature: 900 to 1100°C
Pressure: 100 torr
V/III ratio: 321
TMGa supply rate: 50 to 500 ccm (ramp up)
NH₃ supply rate: 5 to 10 slm (ramp up)
Carrier gas: H₂, N₂
Carrier gas supply rate: 15 slm

As described above, a group III nitride semiconductor substrate 1 in which the sapphire substrate, the buffer layer, and the group III nitride semiconductor layer were laminated in this order was manufactured.

Tables 1 to 7 show the relationship between the "plural factors for adjusting the plane orientation of the growth plane of the group III nitride semiconductor layer" and the plane orientation of the growth plane of the group III nitride semiconductor layer.

**Table 1**

| | | Sapphire main surface | Presence or absence of nitriding treatment when raising temperature | Presence or absence of trimethylaluminum pre-flow step | AIN buffer growth temperature (°C) | GaN growth temperature (°C) | Growth plane of group III nitride semiconductor layer |
|---|---|---|---|---|---|---|---|
| First evaluation | First sample | Plane inclined from m-plane (10-10) at 2° in direction in which plane is parallel with a-plane | Nitriding treatment present | Pre-flow present | 925±25 | 950±25 | Inclined from (-1-12-4) plane at 5.0° in -a-plane direction and inclined at 8.5° in direction in plane is parallel with m-plane |
| | Second sample | | | | | 1050±25 | Inclined from (11-24) plane at 5.0° in a-plane direction and inclined at 8.5° in direction in which plane is parallel with m-plane |

**Table 2**

| | Sapphire main surface | Presence or absence of nitriding treatment when raising temperature | Presence or absence of trimethylaluminum pre-flow step | AIN buffer growth temperature (°C) | GaN growth temperature (°C) | Growth plane of group III nitride semiconductor layer |
|---|---|---|---|---|---|---|
| | | Nitriding treatment present | Pre-flow present | 925±25 | 950±25 | Inclined from (-1-12-4) plane at 4.0° in -a-plane direction and inclined at 7.5° in direction in which plane is parallel with m-plane |
| | | Nitriding treatment present | Pre-flow present | 925±25 | 1075±25 | Inclined from (11-24) plane at 4.0° in a-plane direction and inclined at 7.5° in direction in which plane is parallel with m-plane |
| | | Nitriding treatment present | Pre-flow present | 1085±25 | 950±25 | Inclined at 0.5° in any direction from (11-22) plane |
| | | Nitriding treatment present | Pre-flow present | 725±25 | 950±25 | Inclined at 0.5° in any direction from (11-22) plane |
| Second evaluation | m-plane (10-10) or plane inclined at 0.5° in arbitrary direction from m-plane (10-10) | Nitriding treatment present | Pre-flow present | 1085±25 | 1075±25 | Inclined at 0.5° in any direction from (11-22) plane |
| | | Nitriding treatment present | Pre-flow absent | 1085±25 | 1075±25 | Inclined at 0.5° in any direction from (11-22) plane |
| | | Nitriding treatment present | Pre-flow absent | 925±25 | 950±25 | Inclined from (11-24) plane at 4.0° in a-plane direction and inclined at 7.5° in direction in which plane is parallel with m-plane |
| | | Nitriding treatment absent | Pre-flow present | 925±25 | 950±25 | Inclined at 0.5° from any direction from (10-10) plane |

**Table 3**

| | Sapphire main surface | Presence or absence of nitriding treatment when raising temperature | Presence or absence of trimethylaluminum pre-flow step | AIN buffer growth temperature (°C) | GaN growth temperature (°C) | Growth plane of group III nitride semiconductor layer |
|---|---|---|---|---|---|---|
| | | Nitriding treatment present | Pre-flow present | 950±25 | 975±25 | Inclined from (-1-12-4) plane at 4.4° in -a-plane direction and inclined at 7.9° in direction in which plane is parallel with m-plane |
| | | Nitriding treatment present | Pre-flow present | 950±25 | 1070±25 | Inclined from (11-24) plane at 4.4° in a-plane direction and inclined at 7.9° in direction in which plane is parallel with m-plane |
| | | Nitriding treatment present | Pre-flow present | 1075±25 | 975±25 | Inclined at 1.0° in direction from (11-22) plane to m-plane |
| Second evaluation | Plane inclined from m-plane (10-10) at 0.5° or more and 1.5° or less in direction in which plane is parallel with a-plane | Nitriding treatment present | Pre-flow present | 750±25 | 975±25 | Inclined at 1.0° in direction from (11-22) plane to m-plane |
| | | Nitriding treatment present | Pre-flow present | 1075±25 | 1070±25 | Inclined at 1.0° in direction from (11-22) plane to m-plane |
| | | Nitriding treatment present | Pre-flow absent | 1075±25 | 1070±25 | Inclined at 1.0° in direction from (11-22) plane to m-plane |
| | | Nitriding treatment present | Pre-flow absent | 950±25 | 975±25 | Inclined from (11-24) plane at 4.4° in a-plane direction and inclined at 7.9° in direction in which plane is parallel with m-plane |
| | | Nitriding treatment absent | Pre-flow present | 950±25 | 975±25 | (20-27) plane |

**Table 4**

| | Sapphire main surface | Presence or absence of nitriding treatment when raising temperature | Presence or absence of trimethylaluminum pre-flow step | AIN buffer growth temperature (°C) | GaN growth temperature (°C) | Growth plane of group III nitride semiconductor layer |
|---|---|---|---|---|---|---|
| | | Nitriding treatment present | Pre-flow present | 925±25 | 950±25 | Inclined from (-1-12-4) plane at 5.0° in -a-plane direction and inclined at 8.5° in direction in which plane is parallel with m-plane |
| | | Nitriding treatment present | Pre-flow present | 925±25 | 1070±25 | Inclined from (11-24) plane at 5.0° in a-plane direction and inclined at 8.5° in direction in which plane is parallel with m-plane |
| | | Nitriding treatment present | Pre-flow present | 1080±25 | 950±25 | Inclined at 2.0° in direction from (11-22) plane to m-plane |
| Second evaluation | Plane inclined from m-plane (10-10) at 1.5° or more and 2.5° or less in direction in which plane is parallel with a-plane | Nitriding treatment present | Pre-flow present | 750±25 | 950±25 | Inclined at 2.0° in direction from (11-22) plane to m-plane |
| | | Nitriding treatment present | Pre-flow present | 1080±25 | 1070±25 | Inclined at 2.0° in direction from (11-22) plane to m-plane |
| | | Nitriding treatment present | Pre-flow absent | 1080±25 | 1070±25 | Inclined at 2.0° in direction from (11-22) plane to m-plane |
| | | Nitriding treatment present | Pre-flow absent | 925±25 | 950±25 | Inclined from (11-24) plane at 5.0° in a-plane direction and inclined at 8.5° in direction in which plane is parallel with m-plane |
| | | Nitriding treatment absent | Pre-flow present | 925±25 | 950±25 | (20-27) plane |

**Table 5**

| | Sapphire main surface | Presence or absence of nitriding treatment when raising temperature | Presence or absence of trimethylaluminum pre-flow step | AIN buffer growth temperature (°C) | GaN growth temperature (°C) | Growth plane of group III nitride semiconductor layer |
|---|---|---|---|---|---|---|
| | | Nitriding treatment present | Pre-flow present | 950±25 | 975±25 | Inclined from (-1-12-4) plane at 6.9° in-a-plane direction and inclined at 11.6° in direction in which plane is parallel with m-plane |
| | | Nitriding treatment present | Pre-flow present | 950±25 | 1075±25 | Inclined from (11-24) plane at 6.9° in a-plane direction and inclined at 11.6° in direction in which plane is parallel with m-plane |
| | | Nitriding treatment present | Pre-flow present | 1075±25 | 975±25 | Inclined at 5.0° in direction from (11-22) plane to m-plane |
| Second evaluation | Plane inclined from m-plane (10-10) at 4.5° or more and 5.5° or less in direction in which plane is parallel with a-plane | Nitriding treatment present | Pre-flow present | 750±25 | 975±25 | Inclined at 5.0° in direction from (11-22) plane to m-plane |
| | | Nitriding treatment present | Pre-flow present | 1075±25 | 1075±25 | Inclined at 5.0° in direction from (11-22) plane to m-plane |
| | | Nitriding treatment present | Pre-flow absent | 1075±25 | 1075±25 | Inclined at 5.0° in direction from (11-22) plane to m-plane |
| | | Nitriding treatment present | Pre-flow absent | 950±25 | 975±25 | Inclined from (11-24) plane at 6.9° in a-plane direction and inclined at 11.6° in direction in which plane is parallel with m-plane |
| | | Nitriding treatment absent | Pre-flow present | 950±25 | 975±25 | Inclined at 5.0° in direction from (11-22) plane to m-plane |

**Table 6**

| | Sapphire main surface | Presence or absence of nitriding treatment when raising temperature | Presence or absence of trimethylaluminum pre-flow step | AIN buffer growth temperature (°C) | GaN growth temperature (°C) | Growth plane of group III nitride semiconductor layer |
|---|---|---|---|---|---|---|
| | | Nitriding treatment present | Pre-flow present | 925±25 | 950±25 | Inclined from (-1-12-4) plane at 8.4° in-a-plane direction and inclined at 12.2° in direction in which plane is parallel with m-plane |
| | | Nitriding treatment present | Pre-flow present | 925±25 | 1070±25 | Inclined from (11-24) plane at 8.4° in a-plane direction and inclined at 12.2° in direction in which plane is parallel with m-plane |
| | | Nitriding treatment present | Pre-flow present | 1080±25 | 950±25 | Inclined at 7.0° in direction from (11-22) plane to m-plane |
| Second evaluation | Plane inclined from m-plane (10-10) at 6.5° or more and 7.5° or less in direction in which plane is parallel with a-plane | Nitriding treatment present | Pre-flow present | 750±25 | 950±25 | Inclined at 7.0° in direction from (11-22) plane to m-plane |
| | | Nitriding treatment present | Pre-flow present | 1080±25 | 1070±25 | Inclined at 7.0° in direction from (11-22) plane to m-plane |
| | | Nitriding treatment present | Pre-flow absent | 1080±25 | 1070±25 | Inclined at 7.0° in direction from (11-22) plane to m-plane |
| | | Nitriding treatment present | Pre-flow absent | 925±25 | 950±25 | Inclined from (11-24) plane at 8.4° in a-plane direction and inclined at 12.2° in direction in which plane is parallel with m-plane |
| | | Nitriding treatment absent | Pre-flow present | 925±25 | 950±25 | (10-13) plane |

**Table 7**

| | Sapphire main surface | Presence or absence of nitriding treatment when raising temperature | Presence or absence of trimethylaluminum pre-flow step | AIN buffer growth temperature (°C) | GaN growth temperature (°C) | Growth plane of group III nitride semiconductor layer |
|---|---|---|---|---|---|---|
| | | Nitriding treatment present | Pre-flow present | 925±25 | 975±25 | Inclined from (-1-12-4) plane at 10.4° in -a-plane direction and inclined at 14.8° in direction in which plane is parallel with m-plane |
| | | Nitriding treatment present | Pre-flow present | 925±25 | 1070±25 | Inclined from (11-24) plane at 10.4° in a-plane direction and inclined at 14.8° in direction in which plane is parallel with m-plane |
| | | Nitriding treatment present | Pre-flow present | 1080±25 | 975±25 | Inclined at 10.0° in direction from (11-22) plane to m-plane |
| Second evaluation | Plane inclined from m-plane (10-10) at 9.5° or more and 10.5° or less in direction in which plane is parallel with a-plane | Nitriding treatment present | Pre-flow present | 750±25 | 975±25 | Inclined at 10.0° in direction from (11-22) plane to m-plane |
| | | Nitriding treatment present | Pre-flow present | 1080±25 | 1070±25 | Inclined at 10.0° in direction f rom (11-22) plane to m-plane |
| | | Nitriding treatment present | Pre-flow absent | 1080±25 | 1070±25 | Inclined at 10.0° in direction f rom (11-22) plane to m-plane |
| | | Nitriding treatment present | Pre-flow absent | 925±25 | 975±25 | Inclined from (11-24) plane at 10.4° in a-plane direction and inclined at 14.8° in direction in which plane is parallel with m-plane |
| | | Nitriding treatment absent | Pre-flow present | 925±25 | 975±25 | (10-15) plane |

The column of "Sapphire main surface" in the Tables shows the plane orientation of the main surface of the sapphire substrate. The column of "Nitriding treatment when raising temperature" shows the presence or absence ("Present" or "absent") of a nitriding treatment when raising temperature in the heat treatment step S20. The column "Presence or absence of trimethylaluminum pre-flow step" shows the presence or absence ("present" or " absent ") of the trimethylaluminum pre-flow step. The column of "AlN buffer growth temperature" shows the growth temperature in the buffer layer forming step. The column of "GaN growth temperature" shows the growth temperature in the GaN layer forming step. The column of "Growth plane of group III-nitride semiconductor layer" shows the plane orientation of the growth plane of the group III-nitride semiconductor layer.

According to the results, it is understood that adjusting the "plural factors for adjusting the plane orientation of the growth plane of the group III nitride semiconductor layer" makes it possible to adjust the plane orientation of the growth plane of the group III nitride semiconductor layer to semipolar and Ga-polarity. Based on the result of the first evaluation and the result of the second evaluation, when all of the "plural factors for setting the plane orientation of the growth plane of the group III nitride semiconductor layer to a plane on the N-polarity side" are satisfied, adjusting the "plural factors for adjusting the plane orientation of the growth plane of the group III nitride semiconductor layer" makes it possible to adjust the plane orientation of the growth plane of the group III nitride semiconductor layer to semipolar and N-polarity.

### <Third Evaluation>

The crystallinity of samples produced by this method was evaluated. Three kinds of samples were prepared. Sample A was produced by the method described in this specification, and a {11-23} plane was set as a growth plane. Samples B and C were comparative samples and sample B had a {10-10} plane set as a growth plane. In addition, the sample C had a {11-22} plane set as a growth plane.

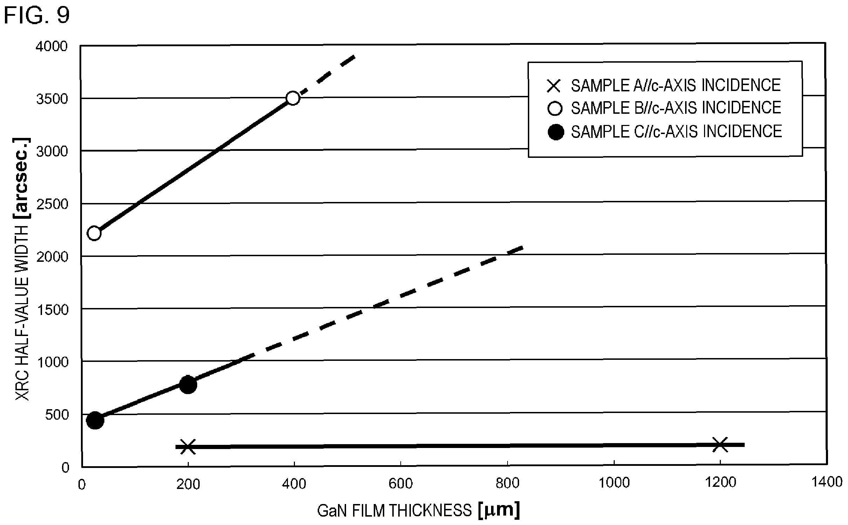

Fig. 9 shows the XRC half width in a case of measuring X-rays incident to each sample in parallel with the projection axis of the c-axis of the group III nitride semiconductor crystal for plural GaN film thicknesses. However, in Sample C in which the main surface is a {11-23} plane, the XRC half width of the {11-22} plane was measured since it was not possible to obtain X-ray diffraction of the {11-23} plane due to the extinction rule.

From Fig. 9, it is understood that, in sample A, the XRC half width hardly changes even if the film thickness of the GaN layer increases. On the other hand, from the samples B and C, it is possible to read that the XRC half width tends to increase as the film thickness of the GaN layer increases.

Examples of reference forms are added below.
1. A group III nitride semiconductor substrate including:
   a group III nitride semiconductor crystal,
   in which the group III nitride semiconductor substrate has a film thickness of 400 µm or more,
   in which exposed first and second main surfaces of the group III nitride semiconductor substrate, having a front and rear relationship, are both semipolar planes, and
   in which a difference in half width of an X-ray Rocking Curve (XRC) between the first and second main surfaces, in which X-rays incident to each surface in parallel with a projection axis of a c-axis of the group III nitride semiconductor crystal are measured, is 100 arcsec or less.
2. The group III nitride semiconductor substrate according to 1,
   in which, for both the half widths of the first and second main surfaces, the half widths of the X-ray Rocking Curve (XRC), in which X-rays incident in parallel with the projection axis of a c-axis of the group III nitride semiconductor crystal are measured, is 500 arcsec or less.
3. A group III nitride semiconductor substrate including:
   a sapphire substrate; and
   a group III nitride semiconductor layer formed over the sapphire substrate and having an exposed main surface which is semipolar and N-polar.
4. The group III nitride semiconductor substrate according to 3,
   in which a film thickness of the group III nitride semiconductor layer is 1 µm or more.
5. The group III nitride semiconductor substrate according to 3 or 4,
   in which a half width of XRC of the main surface of the group III nitride semiconductor layer is 500 arcsec or less in the c projection axis direction.
6. A method for manufacturing a group III nitride semiconductor substrate, the method including:
   a substrate preparation step of preparing a sapphire substrate;
   a heat treatment step of performing a heat treatment on the sapphire substrate after the substrate preparation step;
   a pre-flow step of supplying a metal-containing gas over the sapphire substrate after the heat treatment step;
   a buffer layer forming step of forming a buffer layer over the sapphire substrate under growth conditions of a growth temperature of 800°C or higher and 950°C or lower and a pressure of 30 torr or more and 200 torr or less after the pre-flow step; and
   a growth step of forming a group III nitride semiconductor layer over the buffer layer under growth conditions of a growth temperature of 800°C or higher and 1025°C or lower, a pressure of 30 torr or more and 200 torr or less, and a growth speed of 10 µm/h or more, after the buffer layer forming step.
7. The method for manufacturing a group III nitride semiconductor substrate according to 6, the method further including:
   a peeling step of peeling the sapphire substrate from a laminate including the group III nitride semiconductor layer and the sapphire substrate after the growth step.

This application claims priority based on Japanese Patent Application No. 2016-246908 filed on Dec. 20, 2016, the entire disclosure of which is incorporated herein.

## Claims

1. A group III nitride semiconductor substrate comprising:
a group III nitride semiconductor crystal,
wherein the group III nitride semiconductor substrate has a film thickness of 400 µm or more,
wherein exposed first and second main surfaces of the group III nitride semiconductor substrate, having a front and rear relationship, are both semipolar planes, and
wherein a difference in half width of an X-ray Rocking Curve (XRC) between the first and second main surfaces, in which X-rays incident to each surface in parallel with a projection axis of a c-axis of the group III nitride semiconductor crystal are measured, is 100 arcsec or less.

2. The group III nitride semiconductor substrate according to claim 1,
wherein for both the half widths of the first and second main surfaces, the half widths of the X-ray Rocking Curve (XRC), in which X-rays incident in parallel with the projection axis of a c-axis of the group III nitride semiconductor crystal are measured, is 500 arcsec or less.

3. A group III nitride semiconductor substrate comprising:
a sapphire substrate; and
a group III nitride semiconductor layer formed over the sapphire substrate and having an exposed main surface which is semipolar and N-polar.

4. The group III nitride semiconductor substrate according to claim 3,
wherein a film thickness of the group III nitride semiconductor layer is 1 µm or more.

5. The group III nitride semiconductor substrate according to claim 3 or 4,
wherein a half width of XRC of the main surface of the group III nitride semiconductor layer is 500 arcsec or less in the c projection axis direction.

6. A method for manufacturing a group III nitride semiconductor substrate, the method comprising:
a substrate preparation step of preparing a sapphire substrate;
a heat treatment step of performing a heat treatment on the sapphire substrate after the substrate preparation step;
a pre-flow step of supplying a metal-containing gas over the sapphire substrate after the heat treatment step;
a buffer layer forming step of forming a buffer layer over the sapphire substrate under growth conditions of a growth temperature of 800°C or higher and 950°C or lower and a pressure of 30 torr or more and 200 torr or less after the pre-flow step; and
a growth step of forming a group III nitride semiconductor layer over the buffer layer under growth conditions of a growth temperature of 800°C or higher and 1025°C or lower, a pressure of 30 torr or more and 200 torr or less, and a growth speed of 10 µm/h or more, after the buffer layer forming step.

7. The method for manufacturing a group III nitride semiconductor substrate according to claim 6, the method further comprising:
a peeling step of peeling the sapphire substrate from a laminate including the group III nitride semiconductor layer and the sapphire substrate after the growth step.
